# EUROPEAN PATENT APPLICATION

(11) **EP 0 766 310 A2**
(43) Date of publication of application: **02.04.1997**
(21) Application number: 96306855.6
(22) Date of filing: 20.09.1996
(51) Int. Cl.: H01L 23/485

(54) **Solder bump structure**

(30) Priority: 27.09.1995 JP 249627/95
(71) Applicant: INTERNATIONAL BUSINESS MACHINES CORPORATION, Armonk, NY 10504 (US)
(72) Inventor: Saitoh, Kazuto, Ohmihachiman-shi, Shiga (JP); Shoji, Reijiro, Yamashina-ku, Kyoto-shi, Kyoto (JP)
(74) Representative: Litherland, David Peter

(57) **Abstract**

A solder bump structure for electrically connecting a semiconductor chip to a package substrate comprises two layers formed on the chip 1 which is connected to an electrode 11 of a package substrate 10 in soldering. The lower layer 3a in the double-layer structure does not fuse in soldering, and a definite distance between the substrate and the chip can be secured. The upper layer 3b actually fuses in soldering and operates to electrically connect the bump to the electrode on the package substrate. The melting point of the lower layer is preferably at least 20°C higher than that of the upper layer.

## Description

The present invention relates to the field of solder bump structures for electrically connecting a semiconductor chip to a package substrate and a forming method thereof.

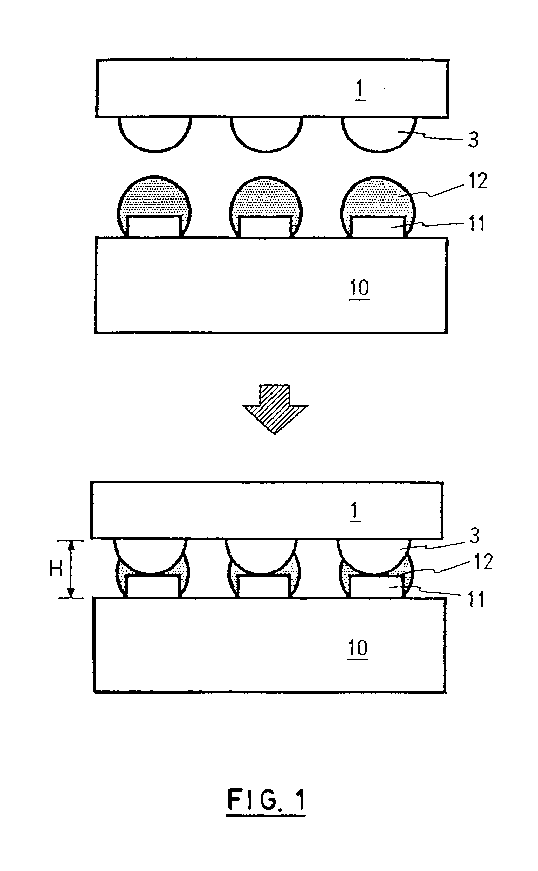

A semiconductor chip with a circuit element formed thereon is packaged on a package substrate for electric connection between chips. At that time, it is required to electrically connecting an electrode of a semiconductor chip to an electrode formed on a package substrate. As a method for this purpose, the flip chip technique as shown in Figure 1 is generally used. In this technique, a solder ball 3 is formed on the external output terminal of a chip 1, on the other hand, a solder bump 12 is formed on wiring 11 of a package substrate 10 and both of them is connected by reflow. Here, the solder ball 3 on the semiconductor chip 1 is made of a solder of higher melting point than that of a solder related to the solder bump 12 and does not fuse by reflow. For example, the solder bump 12 is made of eutectic solder (63 wt.% tin/37 wt.% lead), whereas the solder ball 3 is made of solder (97 wt.% tin/3 wt.% lead) having a higher melting point. In addition, wiring 11 on the package substrate 10 does not fuse even after reflow because of being generally made of gold or copper. As the package substrate 10, a multi-layered printed board, such as an SLC (Surface Laminated Circuitry) substrate formed by the buildup process, is often used.

In this manner, with a method for connecting a semiconductor chip to a package substrate by a flip chip technique on a package substrate, it is required to form a solder 12 for connection on the surface of the package substrate. This is because the space H between the semiconductor chip 1 and the package substrate 10 after soldering needs to be secured.

The space H is a parameter for the connection life of a product. That is, the connection life Nf is given by Nf = M·H/(Δα·l·ΔT), where M: connection constant dependent on a connection material; Δα: difference in thermal expansion factor between a semiconductor chip and a package substrate; 1: distance from the center of a semiconductor chip to a bump at the outermost circumference; and ΔT: temperature range in a heat cycle. When a material, such as solder, for connection (affecting M), the design of a semiconductor chip and a package substrate (affecting 1 and Δα), and the environment under which a package body for a semiconductor chip (affecting ΔT) are identical, the connection life depends upon the space H between the semiconductor chip and the package substrate after connection. Thus, forming solder bumps 12 for connection on the semiconductor substrate is needed to increase the value of H.

However, forming solder bumps for connection on the surface of the semiconductor substrate is problematic for the following reasons: That is, there is a need for forming a solder ball 3 on the surface of the chip and a solder bump 12 on the surface of the package substrate, but supplying solder at a plurality of spots to achieve a single electric connection in this manner complicates the process and accordingly presents a problem from the standpoint of productivity. In addition, forming such a solder bump 12 obstructs the pitch of a pad to be miniaturized, thereby making it difficult to implement a higher-density package substrate. Furthermore, a solder bump is generally formed by the screen printing process, but a mask used in this process is expensive and a change in the specification thereof is difficult.

One prior art technique is disclosed in Japanese Published Unexamined Patent Application No. 3-62926. This is a solder bump structured by forming a high-melting-point solder layer on an electrode formed on the substrate and further a low-melting-point solder layer thereon. Because the high-melting-point solder layer never fuses in soldering, this structure has an advantage that a definite space H can be secured. However, since the thickness of the superficial low-melting-point solder layer is small, a high-melting-point solder layer has to be formed thickly, which is a difficult process. In addition, according to the structure disclosed, the shape of a mushroom having a wide cap requires a large pitch between the solder bumps, which clearly hinders high-density packaging.

Also, Japanese Published Unexamined Patent Application No. 5-243233 discloses a bump structured by forming a lower layer with copper and coating the portion exposed above the insulating layer with an upper layer made of gold. However, the gold coating in this invention is carried out for replenishing the stability of a copper underlayer, but does not aim at prolonging the connection life and promoting the productivity of forming the solder bump in a flip chip connection.

According to a first aspect of the invention there is provided a solder bump structure for electrically connecting a semiconductor chip to a package substrate, comprising: a first part formed on said semiconductor chip and made of metal substantially incapable of melting during soldering; and a second part formed on said first part and capable of melting in soldering for electrical connection to said package substrate.

To secure the connection life, said first part should have a definite height, whereas said second part to fuse in soldering should have a definite volume to secure the electric connection. For this purpose, letting H₁, V₁, H₂ and V₂ be the height from the surface and the volume for the first part and the second part, respectively, the relations H₁ > 30 µm, H₂ > 20 µm, H₁/H₂ = 0.3 to 2 and V₂/V₁ > 1 should be satisfied. Under these conditions, soldering is actually executed to preferably obtain H = 60 to 90 µm.

According to a second aspect of the invention there is provided a package connecting body for a semiconductor chip and a package substrate, comprising: a first metal part formed on said semiconductor chip; a second metal part formed on said package substrate; and a third metal part at least partly interposed between said first metal and said second metal for providing with electrical connection thereof, wherein the distance between said semiconductor chip and said package substrate, secured by said first metal part, said second metal part and said third metal part is equal to or greater than 60 µm.

In a preferred structure, a cap portion in the upper layer spreads out sideways only at the minimum and a producing method thereof should be adopted. This allows for improved integration of the package substrate.

Embodiments of the invention will now be described, by way of example only, with reference to the accompanying drawings in which:
Figure 1 is an explanatory drawing showing the formation of a solder layer in a case of conventional flip chip technique;
Figure 2 is a schematic illustration showing the connection by using a solder bump structure according to a preferred embodiment of the present invention;
Figure 3 shows one embodiment of a solder bump structure;
Figure 4 is a sectional view showing the first producing step of one embodiment of a solder bump structure;
Figure 5 is a sectional view showing the intermediate producing steps of one embodiment of a solder bump structure;
Figure 6 is a sectional view showing the penultimate producing step of one embodiment of a solder bump structure;
Figure 7 shows a second embodiment of a solder bump structure; and
Figure 8 is a sectional view showing the producing steps of the second embodiment of a solder bump structure.

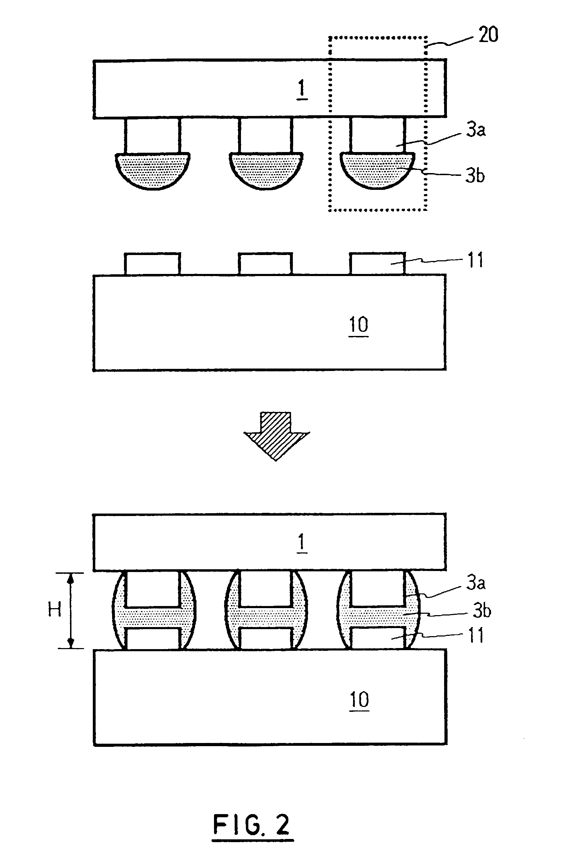

As shown in Figure 2, a preferred embodiment of the present application forms a bump 20 comprising two layers of a lower layer 3a and an upper layer 3b, containing a solder layer 3b to fuse in soldering, on the surface of a semiconductor chip 1 without forming any solder layer on an electrode 11 of a package substrate 10. A distance H between a substrate and a chip is secured by a lower layer 3a not fusing in soldering, an upper layer 3b fusing in soldering, and an electrode 11 on the surface of a package substrate.

Figure 2 shows a sectional view during the period of flip chip connection with a bump. Connection is made in such a manner that the upper-layer metal 3b fuses by reflow and coats an electrode 11 on the package substrate 10 and a lower-layer metal 3a on the semiconductor chip 1. At this time, because the lower-layer metal 3a does not fuse by reflow, a definite distance H is kept between the semiconductor chip 1 and the package substrate 10. Thus, attaining the promotion of the connection life become possible.

In this manner, with the bump according to the invention of the present application, only the upper-layer metal fuses in the time of reflow. Accordingly, the melting point of the lower-layer metal has to be satisfactorily higher than that of the upper-layer metal. From experiments, it is found that the difference in melting point is at least more than 20°C. If the difference is less than 20°C, the lower-layer metal will also fuse in the time of reflow and securing a necessary distance H between the semiconductor chip and the package substrate becomes difficult.

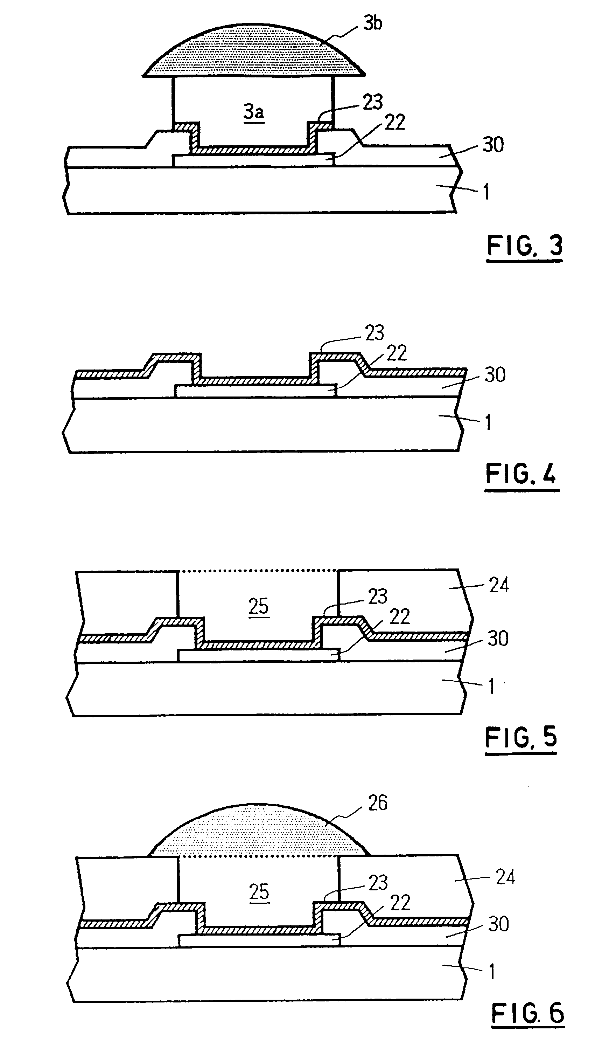

Figure 3 shows the detailed structure of the bump 20 according to a preferred embodiment of the present invention. The lower layer 3a and the upper layer 3b constituting the bump are formed on the semiconductor substrate 1 via an electrode 22 and a barrier metal 23, while the periphery of the bump is coated with an insulating layer 30. This embodiment is so shaped that the upper layer 3b forms a cap and spreads out over the lower layer 3a. In this manner, by spreading out the upper layer 3b, the amount of solder related to the upper layer can be made larger.

The upper-layer metal 3b is a portion to actually fuse in soldering. Thus, a low melting point solder compound is desirable as composing this portion. For example, there is a two-component eutectic solder (63 wt.% tin, 37 wt.% lead) or a three-component eutectic solder (40 wt.% indium, 40 wt.% tin, 20 wt.% lead) containing indium. As another upper-layer metal, there is also, for example, a two-component eutectic solder containing indium, to be concrete, such composition as 52 wt.% indium - 48 wt.% tin or 75 wt.% indium - 25 wt.% lead. The lower-layer metal 3a does not fuse in soldering and serves to secure the distance H between the substrate and the chip. Thus, a metal of higher melting point than that of the upper layer 3b is desirable. For example, a high-eutectic-point solder (3 wt.% tin and 97 wt.% lead), or such metal as gold, copper, nickel or silver is suitable.

A method for forming such a bump will be described by referring to Figure 4 and the following. From the surface of an aluminum electrode 22 formed on the semiconductor substrate 1, the oxide film is removed by the RF plasma etching process. Then, a metal film 23 composed of a plurality of layers is formed on the whole surface. This film operates as a common electrode in the plating which takes place later step. This metal film 23 comprises Ti-Cu, Ti-Ni-Au, Ti-Pd-Au or the like. Next, as a mask for plating, a photoresist 24 is applied. Thereafter, regarding the place at which to form a bump, an opening is provided in the photoresist and a lower-layer metal 25 is formed through plating to much the same thickness as that of the photoresist layer 24 by using the metal film as a common plating electrode as shown in Figure 5. The lower-layer metal helps to secure the distance H between the substrate and the metal. Furthermore, as shown in Figure 6, by plating an upper-layer metal 26 on the lower-layer metal 25, a desired structure related to the invention of the present application is obtained. Thereafter, on removing the photoresist layer 24 and the metal film 23 by wet etching or the like, a bump 20 shown in Figure 2 can be obtained.

Here, letting H₁, V₁, H₂ and V₂ be the height from the surface and the volume for the lower-layer metal and the upper-layer metal, respectively, the range of the preferred embodiment of the invention of the present application is as follows:
H₁ > 30 µm, H₂ > 20 µm, H₁/H₂ = 0.3 to 2 and V₂/V₁ > 1. For example, when the photoresist is 50 µm thick, the above amounts in one embodiment assume the following respective values:
V₁: 0.7 × 10⁻⁴ mm³
V₂: 3.0 × 10⁻⁴ mm³
H₁: 32 µm and H₂: 50 µm,
where H₁/H₂ = 0.6 and V₂/V₁ = 4.3.

Here, too large a value of H₁/H₂ means a situation that the height H₁ of the lower-layer metal is extremely large, but a value of H₁ is limited because of being correlated to the thickness of the photoresist as mentioned above. On the contrary, for too small a value of H₁/H₂, the intention of the invention of the present application to secure the distance H between the substrate and the chip is not fully reflected. When V₂/V₁ is too large, the fused amount of metal in soldering becomes so large as to make the soldering process unstable, whereas a trouble becomes likely to occur in electric connection resultant from soldering when too small.

With another embodiment,
V₁: 1.0 × 10⁻⁴ mm³
V₂: 2.2 × 10⁻⁴ mm³
H₁: 50 µm and H₂: 27 µm,
where H₁/H₂ = 1.9 and V₂/V₁ = 2.2.

In either case, the distance H between the substrate and the chip after soldering ranges from 60 to 90 µm. As an experimental result, it has been found to be the sufficient conditions that H₁ > 30 µm, H₂ > 20 µm and V₂/V₁ > 1. It is H what is of ultimate concern for securing the connection life. H > 60 µm is employed for purposes of calculation. The above conditions for H₁ and H₂ are required to satisfy this minimum value.

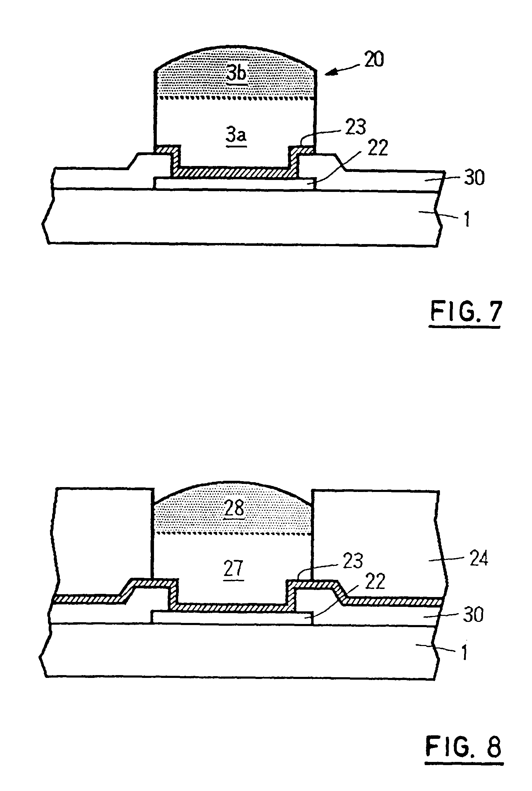

Next, Figure 7 shows one embodiment of aspect in which the upper-layer metal does not spread out like a cap over the lower-layer metal. Also with this aspect, a bump 20 comprising the lower-metal layer 3a and the upper-metal layer 3b are formed on the semiconductor substrate 1 of a chip, via an electrode 22 and a metal film 23, while the periphery of the bump 20 is coated with an insulating layer 30. This aspect differs from the embodiment shown in Figure 3 in that the upper-layer metal 3b has the same sectional area as with the lower-layer metal 3a. With such an aspect of bump, the horizontal (parallel with the substrate surface) consumed area is small and consequently a higher-density package substrate can be achieved.

A method for forming such an aspect of bump is shown in Figure 8, which illustrates the same steps as with Figure 6 showing the method for forming an aspect having a cap. As far as Figures 4 and 5 concern, the common structure is shown. First, for this purpose, it is required to form a thicker photoresist film than needed for forming a bump of the aspect having a cap. In this case, the thickness of the photoresist film is preferably equal to or greater than 70 µm. And, the photoresist film is formed in such a manner that the surface of the lower-metal layer 27 is positioned lower than that of the photoresist to form an upper-metal layer 28. In this case, a bump shape without having a cap is obtained if a surface of the upper-metal layer 28 is lower than the surface of the photoresist 24. For forming this type of bump, it is required to set the thickness of the photoresist to a larger value than usual. With an appropriate embodiment, the thickness of a photoresist film applied at that time is 100 µm or more.

Incidentally, the invention of the present application is attainable also by forming a bump of similar structure on the surface of the package substrate. A solder bump is generally formed by the screen printing process, but nevertheless a mask to be used in this process is expensive and a modification in specification is difficult. Thus, a bump is formed on the surface of the semiconductor chip in a preferred embodiment.

Among the above parameters, H₁, H₂, V₁ and V₂, the factors essential in achieving a desired advantage of the invention of the present application are H₁ and V₂/V₁. First, H₁ is the thickness of the lower metal layer and affects the connection life of products. Thus, this thickness is required to be 30 µm at the minimum. On the other hand, when H₁ is large, there is a merit in connection life, but a problem in manufacturing process that the photoresist has to be applied thickly. In addition, when forming a lower-metal layer by plating, variation in height becomes more likely to occur with increasing value of H₁ and consequently a connection fault between the semiconductor chip and the package substrate becomes likely to occur. Considering these, a reasonable range of H₁ is as follows:${\text{30 µm < H}}_{\text{1}} \text{< 90 µm}$

Next, the result examined about V₂/V₁ will be shown. V₂/V₁ represents the volume ratio of the upper-layer metal to the lower-layer metal. When the volume of the upper-metal layer is too large, the fused amount of metal during reflow becomes too large and consequently there would be a concern that the reflow metal overflows between a plurality of bumps causing an electric short circuit there between. On the other hand, when V₂/V₁ is small, there is a possibility of insufficient connection in spite of execution of reflow. Considering these, a reasonable range of V₂/V₁ is as follows:${\text{1 < V}}_{\text{2}} {\text{/V}}_{\text{1}} \text{< 5}$

Among the parameters mentioned above, H₂ is relatively less effective for the characteristic of a bump. However, H₂ correlates with V₂/V₁.

Thus has been described a solder bump structured in double layers only on the surface of a chip and connects it to an electrode on the surface of a package substrate in soldering, but forming no solder bump on the surface of a package substrate as seen in conventional method. The double-layer structure comprises a lower layer which does not fuse in the course of soldering, and consequently shall have a composition capable of securing a definite distance H between the substrate and the chip. Its upper layer actually fuses in the course of soldering to electrically connect the bump to the electrode on the package substrate. At this time, the melting point of the lower layer is preferably at least 20°C higher than that of the upper layer.

By forming a solder bump on a semiconductor chip alone, the step of forming a solder bump on the surface of a package substrate can be saved and therefore an increase in productivity can be expected. In addition, by making the structure of a solder bump into double-layer structure comprising a high-melting-point metal layer and a metal layer to actually fuse in soldering, the space H between the chip and the substrate can be kept large and consequently the connection life is prolonged. Furthermore, because a preferred version of the formed bump has its spherical tip, the tip need not be made into a spherical shape previously by reflow prior to soldering and this step can be omitted. By assuming a structure in which the part of a cap spreads out to the minimum extent, coping with a high-density package becomes possible.

## Claims

1. A solder bump structure for electrically connecting a semiconductor chip to a package substrate, comprising:
a first part formed on said semiconductor chip and made of metal substantially incapable of melting during soldering; and
a second part formed on said first part and capable of melting in soldering for electrical connection to said package substrate.

2. The bump structure as set forth in Claim 1, wherein
said first part maintains the distance between said semiconductor chip and said package substrate more than a predetermined value.

3. The bump structure as set forth in Claim 1, wherein the height H₁ of said first part satisfies the relation 90 µm > H₁ > 30 µm.

4. The bump structure as set forth in Claim 3, wherein
the height H₂ of said second part satisfies the relation that H₁/H₂ ranges from 0.3 to 2.

5. The bump structure as set forth in Claim 1, wherein the relation 5 > V₂/V₁ > 1 is satisfied where V₁ and V₂ are the volume of said first part and volume of said second part respectively.

6. The bump structure as set forth in Claim 1, wherein said first part is made of metal having a melting point which is at least 20° higher than that of the composition of said second part.

7. The bump structure as set forth in Claim 7, wherein
said first part is made of a solder including 3% gold or tin by weight and 97% lead by weight.

8. The bump structure as set forth in Claim 1, wherein
said second part is made of either a two-component system eutectic solder alloy or a three-component system eutectic solder alloy containing indium.

9. The bump structure as set forth in Claim 1, wherein
the cross-sectional area of said first part and that of said second part are substantially identical.

10. A method for forming a multi-layered bump on a substrate, comprising the steps of:
forming a metal film on an electrode formed on the substrate;
forming a photoresist film on said substrate excluding the portion on said electrode;
plating a first metal by using said metal film as electrode;
plating a second metal on said first metal by using said metal film as an electrode; and
removing said photoresist film.

11. The bump forming method as set forth in Claim 10, wherein
said first metal is less thick than said photoresist film.

12. The bump forming method as set forth in Claim 10, wherein
said photoresist film comprises a resist of high resolution.

13. The bump forming method as set forth in Claim 10, wherein
said second metal is not formed on said photoresist film.

14. A package connecting body for a semiconductor chip and a package substrate, comprising:
a first metal part formed on said semiconductor chip;
a second metal part formed on said package substrate; and
a third metal part at least partly interposed between said first metal and said second metal for providing with electrical connection thereof, wherein
the distance between said semiconductor chip and said package substrate, secured by said first metal part, said second metal part and said third metal part is equal to or greater than 60 µm.
